# EUROPEAN PATENT APPLICATION

(11) **EP 0 547 830 A2**
(43) Date of publication of application: **23.06.1993**
(21) Application number: 92311215.5
(22) Date of filing: 09.12.1992
(51) Int. Cl.: G11C 8/04

(54) **Circuitry and method for sequentially accessing a memory array**

(30) Priority: 19.12.1991 US 812912
(71) Applicant: TEXAS INSTRUMENTS INCORPORATED, Dallas Texas 75265 (US)
(72) Inventor: Tai, Jy-Der, Plano, Texas 75025 (US); Cozad, R.D., Plano, Texas 75074 (US)
(74) Representative: Nettleton, John Victor

(57) **Abstract**

A method and circuitry are provided for sequentially accessing a memory array (112), where the memory array comprises a plurality of memory cells (140a-d). A plurality of the memory cells (140a-d) are selected to output respective stored data bits in response to a word line (138a) coupled to the memory cells (140a-d). The respective stored data bits output by the memory cells (140a-d) are received with a plurality of bit lines (158a-d) each coupled to an associated one of the memory cells (140a-d). Each bit line (158a-d) is selectively coupled to an output line (160b), so that in response to one of a plurality of select lines (124a-d) the output line (160b) accesses the respective stored data bit from an associated one of the bit lines (158a-d). By shifting between the select lines (124a-d), the output line (160b) accesses the respective stored data bits in a predetermined order.

## Description

### TECHNICAL FIELD OF THE INVENTION

This invention relates in general to electronic circuitry and in particular to a method and circuitry for sequentially accessing a memory array.

### BACKGROUND OF THE INVENTION

In many applications, such as a typical first-in- first-out ("FIFO") memory, memory locations of a memory array are sequentially accessed. Consequently, it is desirable to increase a maximum frequency at which such memory locations may be sequentially accessed, so that a speed of such applications may be increased. In typical previous approaches, data from sequential memory locations are prefetched and stored in a pipeline register in order to increase the maximum frequency at which memory locations may be sequentially accessed. However, the maximum frequency achievable by such pre-fetch approaches is limited, because the cycle time of such approaches includes a propagation delay of the pipeline register. Importantly, the prefetching operation increases a complexity of signal lines and also increases a difficulty in achieving appropriate timing.

In another typical approach to sequentially accessing memory locations of a memory array, binary counters specify a series of counts to decoders. The decoders decode the binary counts to specify a particular row and column to the memory array for accessing the specified memory address. A shortcoming of this approach is that binary counters typically impose a limitation that a total number of counts necessary to cycle from a count of zero through to a maximum count and then back to zero is a power of two. Thus, additional circuitry is required if the number of rows or columns of the memory array is not a power of two.

Importantly, the binary counters and the decoders include significant numbers of combination logic gates, which consume layout area in an integrated circuit, and which increase the cycle time by introducing delays in switching between rows and columns. Moreover, the number of combination logic gates increases substantially if the decoders and binary counters are expanded to individually address more memory locations in the memory array. Thus, identical modules may not be repeatedly duplicated as additional rows and columns are added to the memory array. Such cascadability is very desirable for application specific integrated circuit ("ASIC") compiler design programs. By providing a modularized and cascadable architecture, ASIC compiler designs are less complicated and more reliable, which makes them easier to diagnose and troubleshoot.

Consequently, a need has arisen for a method and circuitry for sequentially accessing a memory array, which increases a maximum frequency at which memory locations of the memory array may be sequentially accessed. Importantly, a need has arisen for a method and circuitry for sequentially accessing a memory array, which substantially avoids limitations imposed by decoders and binary counters. Afur- ther need has arisen for a method and circuitry for sequentially accessing a memory array, which reduces a complexity of signal lines and a difficulty in achieving appropriate timing.

### SUMMARY OF THE INVENTION

In a method and circuitry for sequentially accessing a memory array, the memory array comprises a plurality of memory cells. A plurality of the memory cells are selected to output respective stored data bits in response to a word line coupled to the memory cells. The respective stored data bits output by the memory cells are received with a plurality of bit lines each coupled to an associated one of the memory cells. Each bit line is selectively coupled to an output line, so that in response to one of a plurality of select lines the output line accesses the respective stored data bit from an associated one of the bit lines. By shifting between the select lines, the output line accesses the respective stored data bits in a predetermined order.

It is a technical advantage of the present invention that a maximum frequency is increased at which memory locations of the memory array may be sequentially accessed.

It is another technical advantage of the present invention that limitations imposed by decoders and binary counters are substantially avoided.

It is a further technical advantage of the present invention that a complexity of signal lines is reduced.

It is yet another technical advantage of the present invention that a difficulty in achieving appropriate timing is reduced.

### BRIEF DESCRIPTION OF THE DRAWINGS

For a more complete understanding of the present invention, and the advantages thereof, reference is now made to the following description, taken in conjunction with the accompanying drawings, in which:
FIGURE 1 is a schematic diagram of an electrical circuit for sequentially accessing a memory array according to the prior art;
FIGURE 2 is a schematic diagram of an electrical circuit for sequentially accessing a memory array of the preferred embodiment; and
FIGURE 3 is a schematic electrical circuit diagram of a typical transfer gate of the preferred embodiment.

### DETAILED DESCRIPTION OF THE PREFERRED

### EMBODIMENT

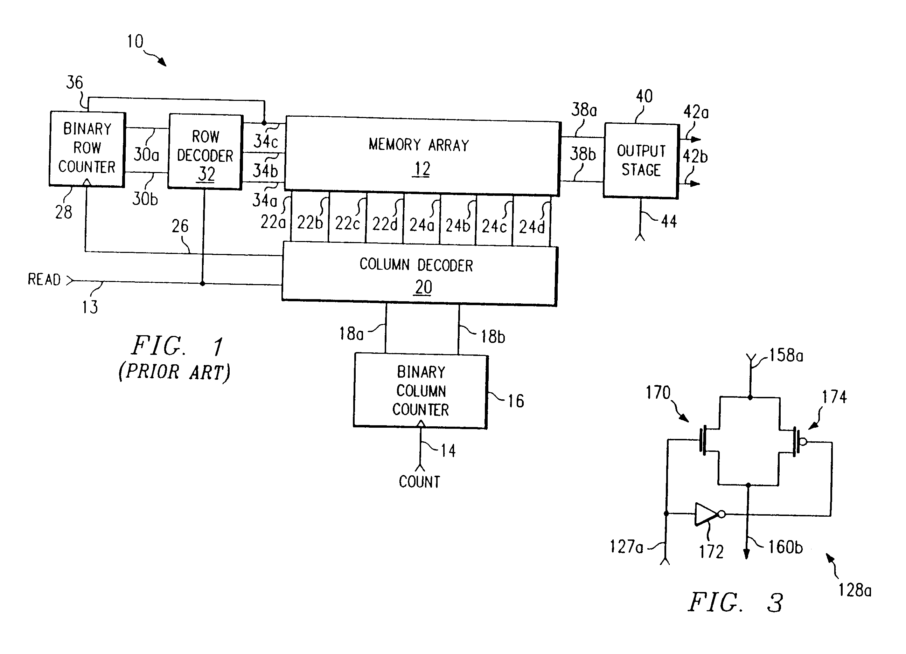

The preferred embodiment of the present invention and its advantages are best understood by referring to FIGURES 1 through 3 of the drawings, like numerals being used for like and corresponding parts of the various drawings.

FIGURE 1 is a schematic diagram of an electrical circuit, indicated generally at 10, for sequentially accessing a memory array 12 according to the prior art. For clarity, memory array 12 has three rows selected by word lines 34a-c and eight columns selected by column select lines 22a-d and 24a-d, although the number of rows and columns may be varied. Consequently, memory array 12 includes twenty-four memory cells located at the intersections of rows and columns, and each memory cell is capable of storing a data bit. A particular memory cell of memory array 12 may be addressed by selecting the column and row that intersect at the particular memory cell's location. After a specified memory cell is addressed in response to a read clock pulse on line 13, memory array 12 outputs the data bit stored at the specified memory cell on output signal line 38a and 38b. In FIGURE 1, the twenty-four memory cells of memory array 12 are addressed in a 12 x 2 manner, such that two memory cells are addressed at any one time for outputting two data bits in response to a read clock pulse on line 13.

In FIGURE 1, a particular column is selected by column select lines 22a-d and 24a-d from a column decoder 20, which sets one of column select lines 22a-d and one of column select lines 24a-d based upon a binary column count specified on lines 18a-b from a binary column counter 16. Binary column counter 16 increments the binary column count in response to a count signal pulse on a line 14. For example, the binary column count is sequenced from zero to one in response to a first pulse on line 14, from one to two in response to a second pulse on line 14, from two to three in response to a third pulse on line 14, and then from three back to zero in response to a fourth pulse on line 14.

Based upon the binary column count on lines 18a-b, column decoder 20 selectively sets one of column select lines 22a-d and one of column select lines 24a-d. In this manner, two memory cells of memory array 12 are addressed at once. If the binary column count is zero, then column decoder 20 sets column select lines 22a and 24a to select first and fifth columns of memory array 12. If the binary column count is one, then column decoder 20 sets column select lines 22b and 24b to select second and sixth columns of memory array 12. If the binary column count is two, then column decoder 20 sets column select lines 22c and 24c to select third and seventh columns of memory array 12. If the binary column count is three, then column decoder 20 sets column select lines 22d and 24d to select fourth and eighth columns of memory array 12.

A particular row is selected by word lines 34a-c from a row decoder 32, which sets one of word lines 34a-c based upon a binary row count specified on lines 30a-b from a binary row counter 28. When the binary column count on lines 18a-b is sequenced from three back to zero, column decoder 20 outputs a count signal pulse on a line 26 to binary row counter 28. In response to such a pulse on line 26, binary row counter 28 increments the binary row count. For example, the binary row count is sequenced from zero to one in response to a first pulse on line 26, and from one to two in response to a second pulse on line 26.

Based upon the binary row count on lines 30a-b, row decoder 32 selectively sets one of word lines 34a-c. If the binary row count is zero, then row decoder 32 sets word line 34a to select a first row of memory array 12. If the binary row count is one, then row decoder 32 sets word line 34b to select a second row of memory array 12. If the binary row count is two, then row decoder 32 sets word line 34c to select a third row of memory array 12.

Word line 34c is connected to a reset input 36 of binary row counter 28. Consequently, when row decoder 32 sets word line 34c, binary row counter 28 resets the binary row count from two back to zero. Otherwise, binary row counter 28 would increment the binary row count from two to three in response to a subsequent pulse on line 26, thereby failing to properly select a row of memory array 12, because memory array 12 in FIGURE 1 has only three rows.

For a particular memory cell addressed by a selected one of word lines 34a-c and a selected one of column select lines 22a-d, memory array 12 outputs a data bit stored at the particular memory cell on output signal line 38a. For a particular memory cell addressed by a selected one of word lines 34a-c and a selected one of column select lines 24a-d, memory array 12 outputs a data bit stored at the particular memory cell on output signal line 38b.

In an output stage 40, each of output signal lines 38a-b is connected to a different back-to-back CMOS inverter pair for separately latching a data bit from each of output signal lines 38a-b. Output stage 40 includes a tri-state buffer to selectively provide the latched data bits on output lines 42a-b, based upon whether an enable line 44 is set.

Row decoder 32 and column decoder 20 are designed to specify memory cells of memory array 12 in either a sequential or non-sequential order. In FIGURE 1, a sequential order of accessing memory cells in memory array 12 is achieved by using binary row counter 28 and binary column counter 16 to specify a sequential series of binary counts to row decoder 32 and to column decoder 20, respectively. By using row decoder 32 and column decoder 20, which are also capable of specifying memory cells in a non-sequential order, the approach of FIGURE 1 has significant shortcomings.

In one shortcoming, binary counters, such as binary counters 16 and 28, typically impose a limitation that a total number of counts necessary to cycle from a count of zero through to a maximum count and then back to zero is a power of two. Consequently, additional circuitry is required, as illustrated in FIGURE 1 by word line 34c being coupled to reset input 36 of binary row counter 28. In another shortcoming, column decoder 20 and row decoder 32 include significant numbers of combination logic gates, which consume layout area in an integrated circuit, which consume additional power, and which increase a cycle time by introducing delays in switching between rows and columns. Moreover, the number of combination logic gates increases substantially if row decoder 32 and column decoder 20 are expanded to individually address more memory cells in memory array 12. Similarly, if binary column counter 16 and binary row counter 28 are expanded to provide higher binary counts for individually addressing more memory cells in memory array 12, then the number of combination logic gates again increases substantially, both in the binary counters and in the decoders. Moreover, binary column counter 16 and binary row counter 28 cannot be expanded in a cascadable manner.

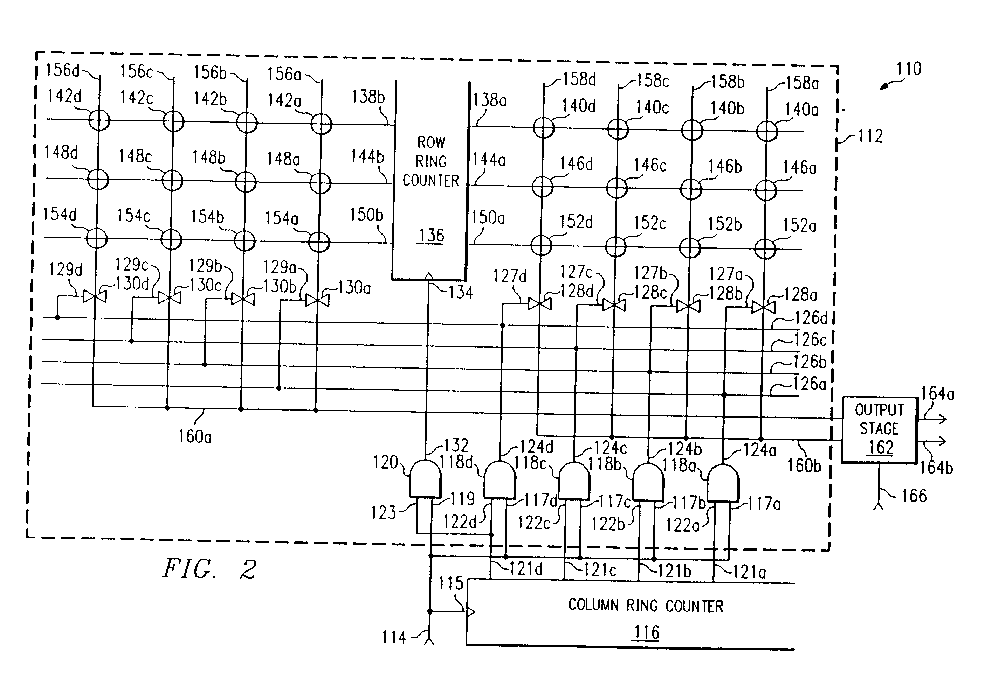

FIGURE 2 is a schematic diagram of an electrical circuit, indicated generally at 110, for sequentially accessing a memory array, indicated by dashed enclosure 112, of the preferred embodiment. Read clock 114 is connected to a clock input 115 of a column ring counter 116, to a first input 117a of an AND gate 118a, to a first input 117b of an AND gate 118b, to a first input 117c of an AND gate 118c, to a first input 117d of an AND gate 118d, and to a first input 119 of an AND gate 120.

A select line output 121a of column ring counter 116 is connected to a second input 122a of AND gate 118a. A select line output 121 b of column ring counter 116 is connected to a second input 122b of AND gate 118b. A select line output 121c c of column ring counter 116 is connected to a second input 122c of AND gate 118c. A select line output 121d of column ring counter 116 is connected to a second input 122d of AND gate 118d and to a second input 123 of AND gate 120.

Transfer gate bus lines 126a-d couple the outputs 124a-d of AND gates 118a-d to select line inputs 127a-d of transfer gates 128a-d and further to select line inputs 129a-d of transfer gates 130a-d. In this manner, a single one of AND gate outputs 124a-d may select more than one transfer gate of memory array 112. As shown in FIGURE 2, one transfer gate is selected in each half of memory array 112. In FIGURE 2, an output 124a of AND gate 118a is coupled to a transfer gate bus line 126a, an output 124b of AND gate 118b is coupled to a transfer gate bus line 126b, an output 124c of AND gate 118c is coupled to a transfer gate bus line 126c, and an output 124d of AND gate 118d is coupled to a transfer gate bus line 126d. Select line inputs 127a-d of transfer gates 128a-d are connected to transfer gate bus lines 126a-d, respectively. Select line inputs 129a-d of transfer gates 130a-d are connected to transfer gate bus lines 126a-d, respectively. Output 132 of AND gate 120 is connected to a clock input 134 of a row ring counter 136.

Word line output 138a of row ring counter 136 is connected to memory cells 140a-d, and word line output 138b of row ring counter 136 is connected to memory cells 142a-d. Word line output 144a of row ring counter 136 is coupled to memory cells 146a-d, and word line output 144b of row ring counter 136 is connected to memory cells 148a-d. Word line output 150a of row ring counter 136 is coupled to memory cells 152a-d, and word line output 150b of row ring counter 136 is connected to memory cells 154a-d. For small memory arrays, word lines 138a-b can be generated by one signal driver. Likewise, word lines 144a-b can be generated by one signal driver, and word lines 150a-b can be generated by one signal driver.

Bit line 156a is coupled through memory cells 142a, 148a and 154a to transfer gate 130a. Bit line 156b is coupled through memory cells 142b, 148b and 154b to transfer gate 130b. Bit line 156c is coupled through memory cells 142c, 148c and 154c to transfer gate 130c. Bit line 156d is coupled through memory cells 142d, 148d and 154d to transfer gate 130d. Bit line 158a is coupled through memory cells 140a, 146a and 152a to transfer gate 128a. Bit line 158b is coupled through memory cells 140b, 146b and 152b to transfer gate 128b. Bit line 158c is coupled through memory cells 140c, 146c and 152c to transfer gate 128c. Bit line 158d is coupled through memory cells 140d, 146d and 152d to transfer gate 128d.

Based upon states of select line inputs 129a-d, transfer gates 130a-d selectively couple bit lines 156a-d, respectively, to output signal line 160a. Based upon states of select line inputs 127a-d, transfer gates 128a-d selectively couple bit lines 158a-d, respectively, to output signal line 160b.

In an output stage 162, each of output signal lines 160a-b is connected to a different back-to-back CMOS inverter pair for separately latching a data bit from each of output signal lines 160a-b. Output stage 162 includes a tri-state buffer to selectively provide the latched data bits on output lines 164a-b, based upon whether an enable line 166 is set.

By using column ring counter 116 and row ring counter 136, the approach of FIGURE 2 achieves a sequential order of accessing memory cells in memory array 112, with significant advantages relative to the approach of FIGURE 1. Importantly, the outputs of column ring counter 116 and row ring counter 136 do not require decoding, so that cycle time is reduced by eliminating substantial numbers of combination logic gates. Moreover, since decoders and binary counters are not required, the approach of FIGURE 2 is cascadable, in that an identical module may be repeatedly duplicated to expand either column ring counter 116 or row ring counter 136 if more columns and rows are added to memory array 112. Such cascadability is very desirable for application specific integrated circuit ("ASIC") compiler design programs. By providing a modularized and cascadable architecture, ASIC compiler designs are less complicated and more reliable, which makes them easier to diagnose and troubleshoot.

For clarity, memory array 112 has three rows (word lines) and eight columns (bit lines), although the number of rows and columns may be varied. Consequently, memory array 112 includes twenty-four memory cells located at the intersections of rows and columns, and each memory cell is capable of storing a data bit.

In the preferred embodiment, the memory cells of memory array 112 are BiCMOS dual-port memory cells which do not require bit line precharging or "pull up" on the read bit line. If a word line selects a row of memory cells, then the selected memory cells respectively output their stored data bits to their connected bit lines. Since memory cells of memory array 112 are not required to charge or discharge bit lines in response to each pulse on read clock 114, control signals are simplified, power is saved, and switching noise in the memory array is reduced.

Also, a shorter access time is achieved, because a selected word line remains enabled while column ring counter 116 multiplexes data bits from the bit lines by turning on sequential ones of transfer gates 128a-d and 130a-d in response to a series of pulses on read clock 114. Advantageously, the bit line charges help drive output stage 162, thereby increasing its speed.

Moreover, after row ring counter 136 shifts to enable a particular word line, memory cells on the word line are ready to be accessed in response to a next pulse on read clock 114. In this manner, a form of multi-stage pipelining of data bits is achieved by continually enabling the word line while multiplexing data bits from the bit lines by turning on sequential ones of transfer gates 128a-d and 130a-d in response to a series of pulses on read clock 114. Consequently, a pipeline register is not required, resulting in simplified control signals and reduced cycle times.

A particular memory cell of memory array 112 may be addressed by specifying the column and row that intersect at the particular memory cell's location. After a specified memory cell is addressed, memory array 112 outputs the data bit stored at the specified memory cell, in response to a pulse on read clock 114. In FIGURE 2, the twenty-four memory cells of memory array 12 are addressed in a 12 x 2 manner, such that two memory cells are addressed at any one time for outputting two data bits in response to a pulse on read clock 114.

Memory array 112 is divided into two halves. A first half of memory array 112 is addressed by word lines 138a, 144a, and 150a, and by select line inputs 127a-d of transfer gates 128a-d. A second half of memory array 112 is addressed by word lines 138b, 144b, and 150b, and by select line inputs 129a-d of transfer gates 130a-d. By dividing memory array 112 into separate halves, word lines 138a-b, 144a-b, and 150a-b have less signal attenuation because they have shorter lengths, thereby reducing a required drive capability of row ring counter 136.

Row ring counter 136 selects one row at a time, by setting word line pair 138a and 138b, word line pair 144a and 144b, or word line pair 150a and 150b. Column ring counter 116 enables one of AND gates 118a-d at a time, by setting one of select line outputs 121 a-d, respectively. In response to a pulse on read clock 114, the selected one of AND gates 118a-d sets one of select line inputs 127a-d and one of select line inputs 129a-d, respectively, thereby selecting a column on each half of memory array 112.

Column ring counter 116 and row ring counter 136 operate as shift registers. In an initial state, column ring counter 116 enables AND gate 118a by setting select line output 121a, and row ring counter 136 sets word line pair 138a and 138b. In response to a pulse on read clock 114, data bits from memory cells 142a and 140a are output on output signal lines 160a and 160b when AND gate 118a sets select line inputs 129a and 127a to turn on transfer gates 130a and 128a. In response to this same pulse on read clock 114, column ring counter 116 shifts to enable the next sequential AND gate 118b instead of AND gate 118a.

In response to a next pulse on read clock 114, data bits from memory cells 142b and 140b are output on output signal lines 160a and 160b, respectively, and column ring counter 116 shifts to enable the next sequential AND gate 118c instead of AND gate 118b. Operation continues in a similar manner in response to subsequent pulses on read clock 114, until column ring counter 116 shifts to enable AND gate 118d.

When column ring counter 116 shifts to enable AND gate 118d, then AND gate 120 is also enabled because input 123 of AND gate 120 is connected to select line output 121d of column ring counter 116. Consequently, in response to a next pulse on read clock 114, data bits from memory cells 142d and 140d are output on output signal lines 160a and 160b, respectively. Also, column ring counter 116 shifts to enable the next sequential AND gate 118a instead of AND gate 118d, thereby repeatedly sequencing orcy- cling through AND gates 118a-d in a circular or ring fashion. In response to this same pulse on read clock 114, row ring counter 136 shifts to set the next sequential word line pair 144a and 144b when AND gate 120 sets clock input 134 of row ring counter 136.

Operation continues in a similar manner, with column ring counter 116 again shifting to enable sequential ones of AND gates 118a-d in response to subsequent pulses on read clock 114, until column ring counter 116 again shifts to enable AND gate 118d. Then, in response to a next pulse on read clock 114, data bits from memory cells 148d and 146d are output on output signal lines 160a and 160b, respectively. Also, column ring counter 116 shifts to enable the next sequential AND gate 118a instead of AND gate 118d. In response to this same pulse on read clock 114, row ring counter 136 shifts to set the next sequential word line pair 150a and 150b.

Column ring counter 116 again cycles through enabling sequential ones of AND gates 118a-d to eventually reenable AND gate 118d. Then, in response to a next pulse on read clock 114, data bits from memory cells 154d and 152d are output on output signal lines 160a and 160b, respectively, and column ring counter 116 shifts to enable the next sequential AND gate 118a instead of AND gate 118d. In response to this same pulse on read clock 114, row ring counter 136 shifts to set the next sequential word line pair 138a and 138b, thereby returning to the initial state by repeatedly sequencing or cycling through word line pairs 138a-d, 144a-d and 150a-d in a circular or ring fashion.

FIGURE 3 is a schematic electrical circuit diagram of a typical transfer gate, indicated generally at 128a, of the preferred embodiment. Circuitry 110 of FIGURE 2 may also include other suitable types of transfer gates, as an alternative to the typical transfer gate shown in FIGURE 3. In FIGURE 3, when select line input 127a is set, an n-channel transistor 170 creates a low impedance path between bit line 158a and output signal line 160b. Also, select line input 127a is coupled through an inverter 172 to a gate of a p-channel transistor 174, so that p-channel transistor 174 creates another low impedance path between bit line 158a and output signal line 160b. In this manner, transfer gate 128a selectively couples bit line 158a to output signal line 160b, based upon a state of select line input 127a. By using both n-channel transistor 170 and p-channel transistor 174, a lower impedance path which avoids strong body-effect is advantageously created between bit line 158a and output signal line 160b than would otherwise be created by only one of the transistors.

With reference to FIGURE 2 and FIGURE 3, in the preferred embodiment, a pulse on read clock 114 has a duration of approximately 3 nanoseconds, such that a data bit from bit line 158a is transferred to output signal line 160b. After the pulse on read clock 114 is finished, a data bit from output signal line 160b reaches output stage 162 after another approximately 2 nanoseconds. If enable line 166 was set before or during the pulse on read clock 114, then the data bit reaches output line 164b in another approximately 2 nanoseconds after the data bit reaches output stage 162.

Relative to circuitry 10 of FIGURE 1, circuitry 110 of FIGURE 2 increases a maximum frequency at which memory locations of the memory array may be sequentially accessed. For example, in the range of memory arrays from 4 bit x 4 bit through 2 kilobit x 4 bit, typical access times of circuitry 110 range from approximately 4 nanoseconds to 6 nanoseconds, and typical cycle times range from approximately 6 nanoseconds to 13 nanoseconds. Comparatively, typical access times of circuitry 10 range from approximately 10 nanoseconds to 18 nanoseconds, and typical cycle times range from approximately 9 nanoseconds to 16 nanoseconds. These times are approximate and depend upon the specific process technology used in a particular circuit.

Although the present invention and its advantages have been described in detail, it should be understood that various changes, substitutions and alterations can be made herein without departing from the spirit and scope of the invention as defined by the appended claims.

## Claims

1. Circuitry for sequentially accessing a memory array, the memory array comprising a plurality of memory cells, comprising:
at least one output line for accessing a data bit;
at least one word line coupled to a plurality of the memory cells for selecting the memory cells to output respective stored data bits;
a plurality of bit lines, each of said bit lines being coupled to an associated one of the memory cells for receiving said respective stored data bit from said associated memory cell;
a plurality of select lines, each of said select lines being operable to selectively couple an associated one of said bit lines to said output line so that said output line accesses said respective stored data bit from said associated bit line; and
shifting circuitry for shifting between said select lines so that said output line accesses said respective stored data bits in a predetermined order.

2. The circuitry of Claim 1 wherein said shifting circuitry shifts between said select lines in response to a pulse on a clock line.

3. The circuitry of Claim 1 wherein said shifting circuitry is operable to repeat said predetermined order of access in a ring fashion.

4. The circuitry of Claim 1 wherein said shifting circuitry comprises a shift register.

5. The circuitry of Claim 4 wherein said shift register forms a ring counter.

6. The circuitry of Claim 1 wherein said shifting circuitry comprises:
a clock line for providing a pulse;
a shift register coupled to said clock line for shifting between a plurality of enable lines in response to said pulse; and
a plurality of logic gates each operable to assert an associated one of said select lines during said pulse in response to said shift register shifting to an associated one of said enable lines.

7. The circuitry of Claim 1 and further comprising row shifting circuitry coupled to each said word line for shifting between word lines to select a predetermined sequence of rows.

8. The circuitry of Claim 7 wherein said row shifting circuitry shifts to a next sequential word line in response to said output line having accessed said respective stored data bits in said predetermined order.

9. The circuitry of Claim 7 wherein said row shifting circuitry is operable to repeat said predetermined sequence of said rows in a ring fashion.

10. The circuitry of Claim 7 wherein said row shifting circuitry comprises a row shift register.

11. The circuitry of Claim 10 wherein said row shift register forms a row ring counter.

12. The circuitry of Claim 1 and further comprising: at least one additional output line; and at least one additional bit line, wherein at least one of said select lines is further operable to selectively couple said additional output line to said additional bit line.

13. A method of sequentially accessing a memory array, the memory array comprising a plurality of memory cells, comprising the steps of:
selecting a plurality of the memory cells to output respective stored data bits in response to a word line coupled to the memory cells;
receiving said respective stored data bits output by said memory cells with a plurality of bit lines each coupled to an associated one of the memory cells;
selectively coupling each said bit line to an output line, so that in response to one of a plurality of select lines said output line accesses said respective stored data bit from an associated one of said bit lines; and
shifting between said select lines so that said output line accesses said respective stored data bits in a predetermined order.

14. The method of Claim 13 wherein said shifting step comprises the step of shifting between said select lines in response to a pulse on a clock line.

15. The method of Claim 13 wherein said shifting step comprises the step of repeating said predetermined order of access in a ring fashion.

16. The method of Claim 13 wherein said shifting step comprises the steps of:
providing a pulse on a clock line;
shifting between a plurality of enable lines in response to said pulse; and
asserting an associated one of said select lines during said pulse in response to said shift register shifting to an associated one of said enable lines.

17. The method of Claim 13 and further comprising the step of shifting between word lines to select a predetermined sequence of rows.

18. The method of Claim 17 wherein said word line shifting step comprises the step of shifting to a next sequential word line in response to said output line having accessed said respective stored data bits in said predetermined order.

19. The method of Claim 17 wherein said word line shifting step comprises the step of repeating said predetermined sequence of said rows in a ring fashion.

20. The method of Claim 13 and further comprising the step of selectively coupling at least one additional bit line to at least one additional output line, in response to at least one said select line.
